(19) Europäisches Patentamt / European Patent Office / Office européen des brevets

(11) **EP 4 412 415 A1**

(12) **EUROPEAN PATENT APPLICATION**

(43) Date of publication:
**07.08.2024 Bulletin 2024/32**

(21) Application number: **24153940.2**

(22) Date of filing: **25.01.2024**

(51) International Patent Classification (IPC):
**H05K 7/14** (2006.01)    **H05K 9/00** (2006.01)

(52) Cooperative Patent Classification (CPC):
**H05K 9/0062; E06B 5/18; H02B 1/38;
H05K 7/1495; H05K 9/0009**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **25.01.2023 EP 23153356**

(71) Applicant: **Hans-Erik Johansson I Hagstad AB
335 32 Gnosjö (SE)**

(72) Inventor: **Johansson, Hans-Erik
335 32 Gnosjö (SE)**

(74) Representative: **AWA Sweden AB
Box 5117
200 71 Malmö (SE)**

(54) **ELECTROMAGNETICALLY SHIELDED ELECTRONICS CABINET**

(57)    A TEMPEST-grade electromagnetically shielded electronics cabinet (100) comprises a body (102) and a front plate (104), said cabinet (100) further being provided with a linear motion mechanism (200, 200b) comprising a movable frame (202) slidably suspended with respect to said body (102), connectable to said front plate (104), and provided with a driving member (210); and an actuator plate (208) pivoted at said body (102), and provided with a guiding track (211), wherein said driving member (210) is configured to engage with said guiding track (211) for driving said linear motion upon actuation of said actuator plate (208).

Fig. 1

EP 4 412 415 A1

## Description

Field of the invention

The present inventive concept relates to a TEMPEST-grade electromagnetically shielded electronics cabinet.

Background

An electromagnetically shielded electronics cabinet may be used to prevent emission of electromagnetic waves, for example to avoid electromagnetic interference or the leakage of critical information from electronic equipment, such as a network switch or server, placed in the cabinet.

For this application, standards, usually referred to using the term "TEMPEST", or Swedish "ROS", are established that require attenuation up to the order of 100 dB at frequencies up to 10 GHz.

Such cabinets known in the prior art are generally heavy, bulky, and/or hard to move. There is a need to improve such cabinets.

Summary

According to the present inventive concept there is provided a TEMPEST-grade electromagnetically shielded electronics cabinet, comprising a body and a front plate, said cabinet further being provided with a linear motion mechanism comprising a movable frame slidably suspended with respect to said body, connectable to said front plate, and provided with a driving member; and an actuator plate pivoted at said body, and provided with a guiding track, wherein said driving member is configured to engage with said guiding track for driving said linear motion upon actuation of said actuator plate.

Such an arrangement may allow for a particularly compact and lightweight mechanism for sealing the cabinet, allowing to a cabinet that may be small, compact, convenient and/or transportable, while still allowing for convenience of operation and excellent electromagnetic shielding of the cabinet through excellent electromagnetic sealing between the end plate and the body of the cabinet.

For example, the present inventive concept allows for a TEMPEST-grade electromagnetically shielded electronics cabinet the size of a personal computer cabinet.

The linear motion mechanism may be a first linear motion mechanism and the cabinet may further comprise a second linear motion mechanism, wherein an actuator plate of the second linear motion mechanism is connected to the actuator plate of the first linear motion mechanism through a shaft.

While not strictly necessary, the doubling of the mechanism - i.e., having the first linear motion mechanism and the second linear motion mechanism - may improve the stability of the cabinet and may allow for a particularly compact but still strong mechanism allowing for excellent electromagnetic shielding.

The shaft may run between a first fixed frame, and a second fixed frame, each connected to a main part of the body, so that the shaft runs behind the main part of the body in the direction of the linear motion. This may allow for a particularly compact configuration.

The first linear motion mechanism may be located at a first end of the electronics cabinet and the second linear motion mechanism may be located at a second end of the electronics cabinet, wherein the first end is located opposite to the second end in a direction transversal to the linear motion.

Such an arrangement may even further allow for a particularly compact but still strong mechanism allowing for excellent electromagnetic shielding.

One of the body and the front plate may be provided with an electromagnetically-sealing gasket and the other of the body and the front plate being provided with an edge fitting into the gasket, for electromagnetically sealing the front plate to the body. For example, the electromagnetically sealing gasket may be a beryllium gasket.

The front plate may be removable from the movable frame. This may allow for easy access to the interior of the cabinet.

The front plate may attachable to the movable frame through one or more hooks provided at the movable frame. This is a particularly convenient arrangement for attaching the front plate to the movable frame.

The actuator plate may be supported at the stationary frame by a spring. Thereby, the actuator plate may be supported so that any force applied to it does not have to work against the weight of the actuator plate. This makes the mechanism easier to operate. Such support may for example be provided by a gas spring.

The guiding track of the actuator plate may have a variable slope along the guiding track. As slope should be understood a deviation from a purely circularly circumferential tangent direction of the guiding track of the actuator place, which may determine a transmission ratio between rotation actuation of the actuator plate and the corresponding linear movement. As transmission ratio should be understood an infinitesimal length traveled as part of the linear motion divided by an infinitesimal rotation of the actuator plate. Through the variable slope the transmission ratio may be adjusted according to need along the linear motion.

Generally, a high transmission ratio may be desirable when the front plate is moving freely, while a low transmission ratio may be desirable when there is an additional force to overcome, for example at a position when a groove of a gasket is to be mated with an edge. For example, through an appropriate choice of slopes, the force felt when operating the driving member may be kept roughly constant during the whole linear motion.

In other words, the transmission ratio may be adjusted so that there is a relatively high transmission ratio when the end plate is traveling freely and a relatively low transmission ratio when an edge on the body and/or the end plate meets an electromagnetically sealing gasket on the other of the body and the end plate. Thereby levelling out the effort needed by a user to actuate the movement through actuating the actuating plate, this allow for convenience of operation.

## Brief description of the drawings

The above, as well as additional objects, features and advantages of the present inventive concept, will be better understood through the following illustrative and non-limiting detailed description of preferred embodiments, with reference to the appended drawings, where the same reference numerals will be used for similar elements, wherein:

> Figs 1, 2, and 3 are perspective views of an electronics cabinet.
> Fig. 4 is an isolated view of linear motion mechanisms and front plate of the electronics cabinet.
> Figs 5-8 show a sequence of motions to close the electronics cabinet.

## Detailed description

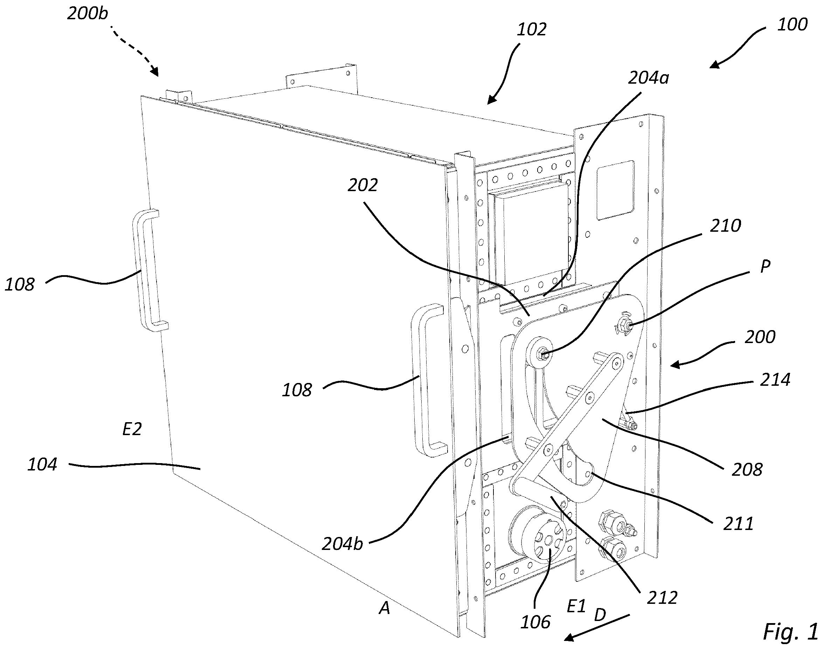

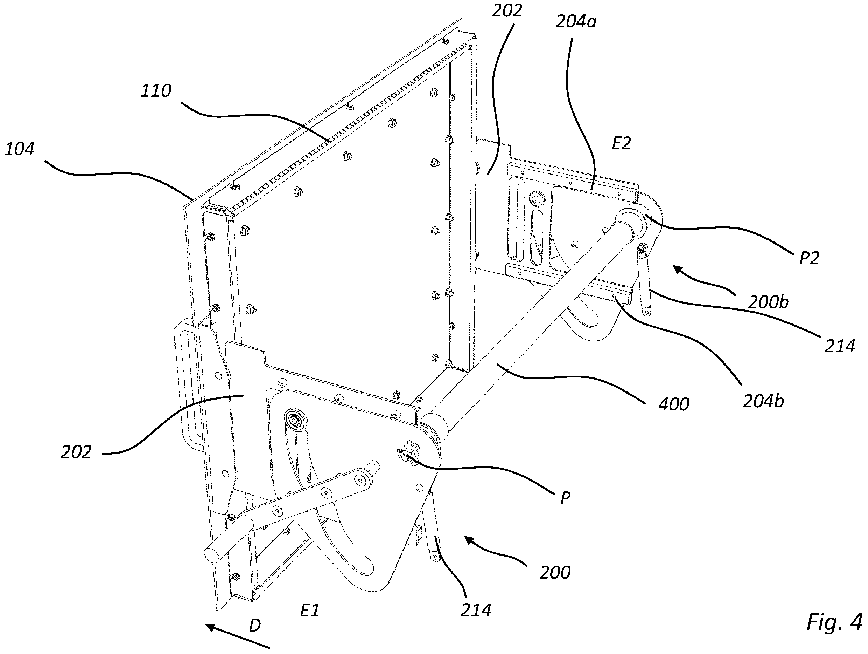

Figs 1-3 show a TEMPEST-grade electromagnetically shielded electronics cabinet 100. Fig. 4 shows parts of the cabinet in isolation.

Such a cabinet or other enclosure can be used in a sensitive environment where processing devices in the cabinet, such as servers, electronically process unencrypted or encrypted sensitive information. The cabinet 100, made from an electrically conductive material, which may be thick sheet metal, functions as a Faraday cage, containing within its enclosure any electromagnetic radiation from the processing devices, thereby preventing the leakage of sensitive information. The processing devices may communicate with nodes outside the cabinet via non-electric signal leads, such as optical fibers, which are terminated by means of connectors at each if their ends. The signal-leads must be non-electric in order not to spoil the functioning of the shielding, as an electric signal lead would act as an antenna, spoiling the shielding of the inside of the cabinet or enclosure. The signal leads may convey less sensitive information or the information carried by them may be encrypted. Furthermore, the conveyed optical signals as such usually give negligible leaked radiation, preventing interception of such signals, unless the fibers are tampered with.

In addition to the shielding situation described above, the cabinet may be useful in other situations where considerable attenuation at a connection into a Faraday cage is needed. For instance, as the effect provided is more or less reciprocal, the cabinet could protect sensitive equipment in a cabinet from external electromagnetic interference, such as electromagnetic pulses with high energy.

Adequate TEMPEST-grade electromagnetic shielding requires that the the cabinet must be free of any large apertures. Any aperture into the cabinet may act as waveguide for electromagnetic signals.

As is well known per se, an attenuating feedthrough can be obtained by means of a waveguide below-cutoff, WBCO. For example, the waveguide, made from a conductive material, has a cavity 214, open at both ends, with a circular cross section with diameter $D$ and a length $l$. The waveguide extends through a wall in a Faraday cage 201.

Electromagnetic waves can propagate through a waveguide in a number of different modes, corresponding to different solutions to the Maxwell equations. These modes are distinguished by different configurations of the electric and magnetic fields. Each of these modes has a cut-off frequency, below which no substantial propagation in that mode is possible. Below the lowest cut-off frequency of all possible modes, no substantial propagation of electromagnetic waves is possible at all. Instead, signals suffer exponential attenuation. For example, in a circular waveguide, the mode with the lowest cut-off frequency is the $TE_{11}$ (transverse electric) mode. The cut-off frequency $f_c$ of that mode can be shown to be, to three significant figures,

$$f_c = \frac{0.586\,v}{D},$$

where $v$ is the propagation speed of the waveguide dielectric, i.e., the non-conductive material forming the bulk of the waveguide cavity. In air, $v$ is to a good approximation $3 \times 10^8$ m/s. Below this cut-off frequency, over a distance $l$, an electromagnetic wave with frequency $f$ suffers a total attenuation of again to three significant figures,

$$A = 32.0\,\frac{l}{D}\sqrt{1 - \left(\frac{f}{f_c}\right)^2}\ \mathrm{dB}.$$

It can thus be seen that to maximize attenuation of signals of a certain frequency requires as high a cut-off frequency as possible, and thus as narrow a waveguide/aperture as possible, as well as a long a waveguide/aperture as possible. It can also be seen that the larger the diameter a waveguide/aperture has, the longer the waveguide/aperture needs to be to achieve target attenuation.

Referring back to Figs 1-4, the cabinet 100 comprises a body 102 and a front plate 104, attachable to the body.

The cabinet 100 may be provided with one or more feed-throughs 106 as discussed above. For example such a feedthrough may be according to international patent application PCT/SE2020/050471, hereby incorporated by reference in its entirety. The feed-through 106 where the optical fibers extend out of the cabinet 100 ensures that electromagnetic radiation does not escape the cabinet, risking interception by a third party nearby.

Further, the cabinet comprises and/or is provided with a linear motion mechanism 200, serving the purpose of allowing for the front plate to attach to the body 102, as will be elaborated upon further in the following.

As shown in Figs 1-2, and 4, the linear motion mechanism 200 may at least partially be located at a first transversal end E1 of the cabinet 200 with respect to the direction D of the linear motion.

The linear motion mechanism 200 comprises a movable frame 202.

As shown in Figs 1-2, and 4, the front plate 104 is connectable to the movable frame 202. Typically, the front plate 104 may further be removable from the movable frame, which may allow easy access to the inside of the cabinet 100, as will be elaborated further upon below.

The movable frame 202 is slidably suspended at the body 102 in the direction D of the linear motion. For example, as shown in Figs 1-2, and 4, the movable frame 202 may be suspended at the body 102 through a first rail 204a located at an upper end of the movable frame 202 and a second rail 204b located at a lower end of the movable frame 202. Any other number of rails is equally possible, such as one rail or three rails. The rails 204a, 204b may for example be guide rods, and/or ball-bearing rails, or the like.

Further, the movable frame 202 is provided with a driving member 210, attached at the movable frame. For example, as shown in Figs 1-2, the driving member 210 may be a ball bearing, or a small wheel mounted on a ball bearing, rotationally attached at the movable frame 202. Generally, the driving member may be any protruding member capable of engaging with a guiding track, as will be elaborated further upon below.

Further, the linear motion mechanism 200 comprises an actuator plate 208. The actuator plate is pivoted at the body 102 at a pivot point P. The pivoting of the actuator plate 208 at the pivot point P may, for example, be achieved through a ball bearing.

Offset from the pivot point P, the actuator plate 208 is provided with a guiding track 211 for the driving member 210 of the movable frame 202.

The linear motion mechanism 200 being provided with the driving member 210, allows, through engagement of the driving member 210 of the movable frame 202 with the guiding track 211 of the actuator plate 208, for driving of the linear motion in the direction D of the movable frame 202, and thereby of the front plate 104, relative to the body 102.

Such driving of the linear motion occurs upon actuation, i.e., the driving of a rotation of the actuator plate 208 around the pivot point P through some external force and/or torque, typically as effected by a user.

For example, as shown in Fig. 1, the actuator plate 208 may be connected to a handle or lever 212, through which the user may cause actuation of the actuator plate 208 and thereby cause driving of the linear motion through the driving member 210. Alternatively (not shown), the actuator plate 208 may be driven by a motor or actuator.

As evident from Fig. 1, the guiding track 211 may be approximately circumferential around the pivot point P, with a spiraling shape, wherein a slope of the guiding track, i.e., a deviation from a purely circularly circumferential shape, may determine a transmission ratio between rotation actuation of the actuator plate 208 and the corresponding linear movement. A will be elaborated further upon below, this slope may be variable along the guiding track 211.

Furthermore, there is a gas spring 214 attached to the actuator plate 208, which may carry the weight of the actuator plate 208. This may make the actuator plate 208 easier to operate, as any applied force and/or torque will not have to counteract at least part of the weight of mechanism. Furthermore, this avoids the actuator plate 208 spontaneously falling back into a lower position due to gravity. The other end of the gas spring 214 is attached to the body 102.

The linear motion mechanism 200 as described above may be a first linear motion mechanism and the cabinet may further comprise a second linear motion mechanism 200b, as best visible in Fig. 4, showing the first linear motion mechanism 200, the second linear motion mechanism 200b and the front plate 104.

Just as the first linear motion mechanism 200, the second linear motion mechanism may comprise a movable frame 202 and an actuator plate 208 and be configured as described above for the first linear motion mechanism.

As evident from Fig. 4 the second linear motion mechanism 200b may be arranged with mirror symmetry with respect to the first linear motion mechanism 200. Thus, any structure visible in the figures in relation to the second linear motion mechanism 200b equally applies to the first linear motion mechanism, mutatis mutandis.

Further, again as evident at least from Figs 1, 2, and 4, the second linear motion mechanism 200b may be located at a second end E2 of the electronics cabinet, and the first linear motion mechanism 200 at the first end E1, wherein the first end E1 is located opposite to the second end E2 in the direction transversal to the direction D of the linear motion.

Further again, as best visible in Fig. 4, the actuator plate 208 of the first linear motion mechanism 200 may be rigidly connected to the actuator plate 208 of the second linear motion mechanism through a shaft 400, connecting the pivot points P and P2 of, respectively, the actuator plate 208 of the first linear motion mechanism 200 and the actuator plate 208 of the second linear motion mechanism 200b.

In the particular configuration presented herein, the shaft 400 may run between a first fixed frame 150, and a second fixed frame 152, each connected to a main part of the body 102, so that the shaft 400 runs behind the main part of the body 102 in the direction D of the linear motion.

Further, in this configuration, each of the pivot points P and P2 may be located at the respective fixed frame 150, 152.

Fig. 4 further shows the inside of the endplate 104 as attached to the movable frame 202 of the first linear motion mechanism 200 and the movable frame 202 of the second linear motion mechanism 200b.

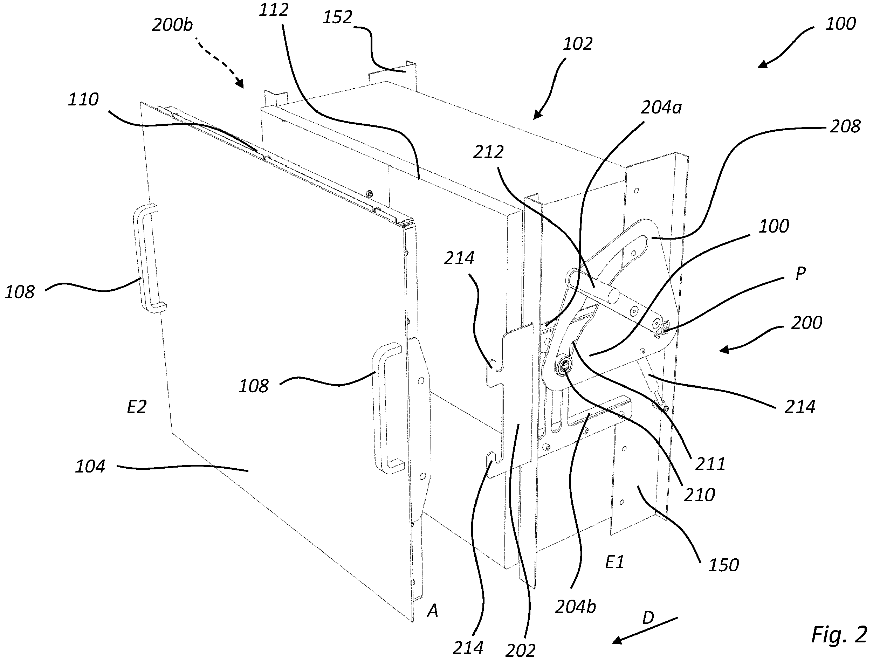

As visible in Fig. 4, the inside of the endplate 104 may comprise an electromagnetically-sealing gasket 110 matching an edge 112 (cf. Fig. 2) of the body 102. As shown, the gasket 110 may run along the perimeter of the inside of the end plate 104 adjacent to the edge of the endplate 104. The gasket may for example be made of from beryllium to provide TEMPEST-grade electromagnetic shielding without gaps. The gasket 110 provides a groove to which the edge 112 of the body is to be mated.

Equally possible (not shown) is a configuration where an edge is provided at the end plate 104 and a gasket is provided at the body 102.

Having the gasket 110 located on the endplate 104 to be mated with the edge 112 of the body 102, as opposed to having an edge located on the endplate 104 and the gasket located on the body 102, which also is possible, allows for easy maintenance, repairs, and replacement of the gasket 110.

Fig. 2 shows a state of the cabinet 100 where front plate 110 is detached from the movable frame 202. As evident, the movable frame may be provided with one or more hooks 214 for hanging, and thereby attaching, the front plate on the movable frame 202. In the particular example of Fig. 2, there are two hooks 214.

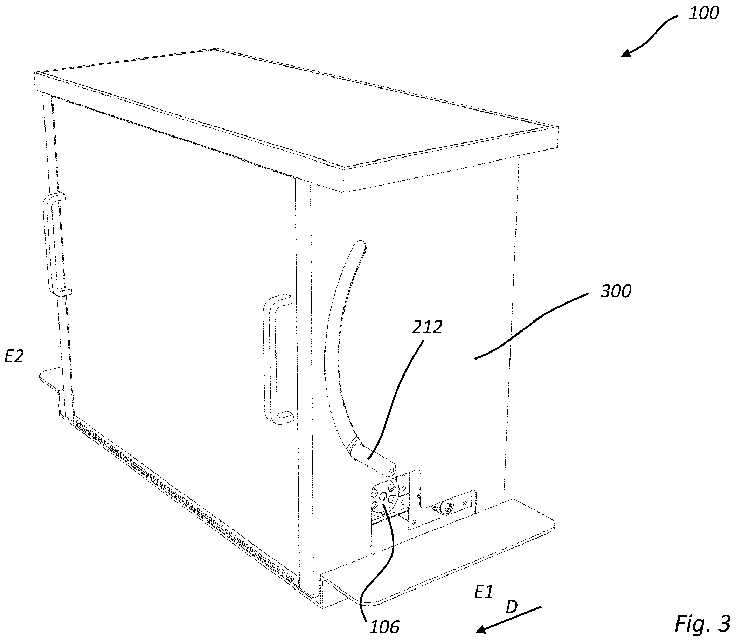

Fig. 3 shows the electronics cabinet 100 in an installed configuration. A cover plate 300 may cover the linear motion mechanism 200 (cf. Figs 1-2). The cover plate may have openings for the handle 212 and the feedthrough 106.

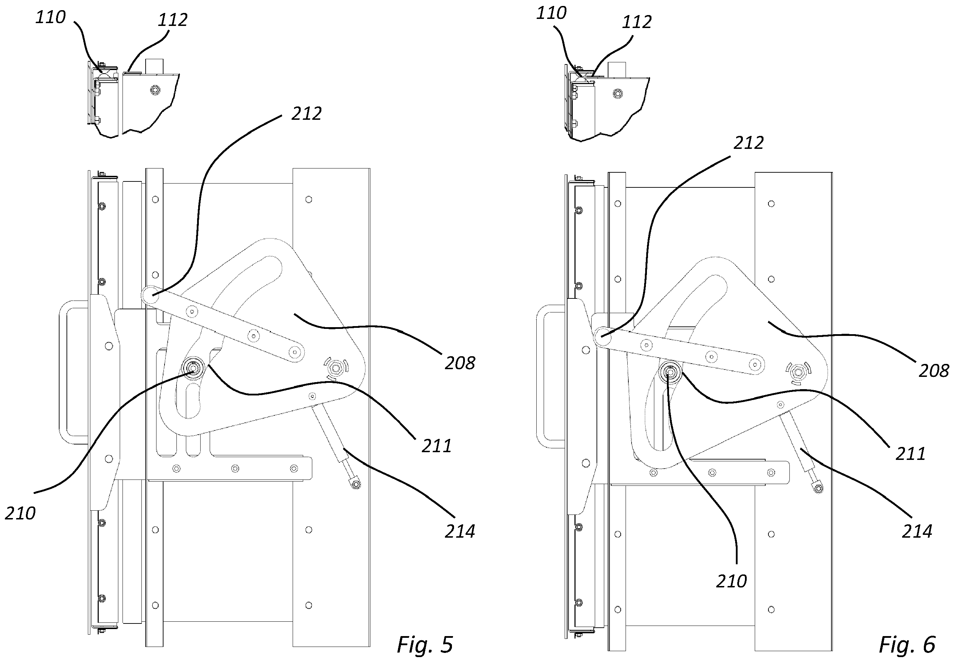

Figs 5-8 show a sequence of motions to close the electronics cabinet 100. In each of those figures, a side view of the linear motion mechanism is shown, as well as a cross sectional view showing the gasket 110 of the front plate 104 meeting the edge 112 of the body 102. Naturally, operating this sequence in opposite order may allow for opening of the electronics cabinet 100.

To close the cabinet, a user, for example an installer, may attach the front plate 104 to the movable frame 202, for example using the hooks 214 (cf. Fig. 2). The user may then actuate the actuator plate 208 through pulling the handle 212.

As shown in the position in Fig. 5, the guiding track 211 may initially have a slope providing a relatively high exchange ratio between rotational actuation of the actuator plate 208 and linear motion of the movable frame 202, and thereby of the front plate 104.

Then, in the position of Fig. 6, the driving member 210 may reach a point of discontinuity of the slope of the guiding track 211. This position may correspond to the edge 112 of the body just barely reaching the gasket 110.

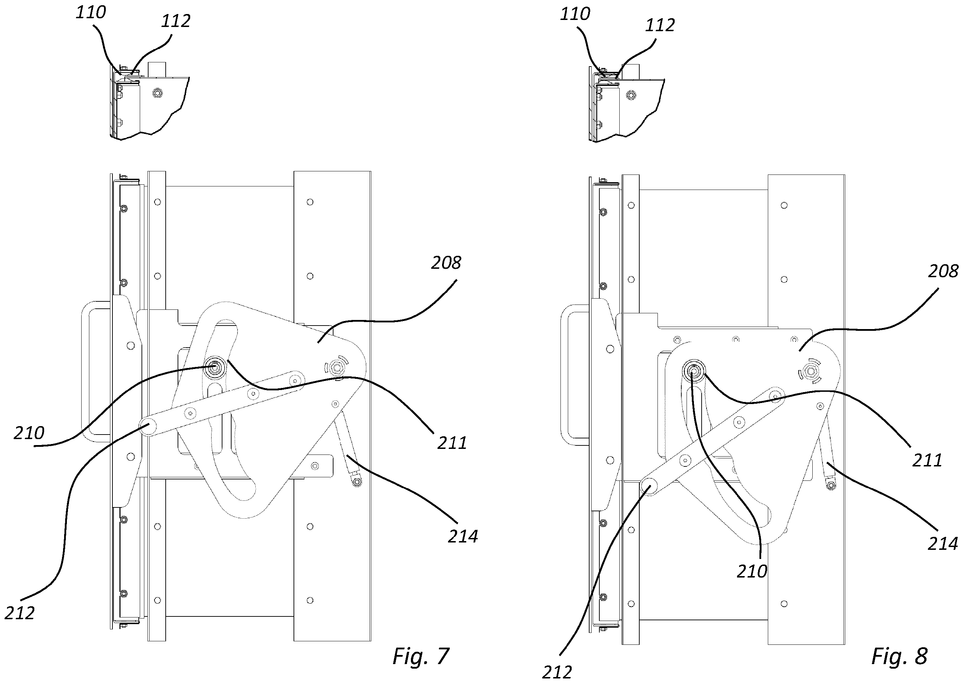

Then as the movement progresses, as depicted in Fig. 7, the guiding track 211 may have a relatively lower slope so that a relatively low exchange ratio is provided between the exchange ratio between rotational actuation of the actuator plate 208 and linear motion of the movable frame 202, and thereby of the front plate 104, as compared to the relatively high ratio of Fig. 5. Hereby, more force may be provided to push the edge 112 into the gasket 110, without increased effort being needed by the user. For example, the slopes may be adjusted so that the force provided at the linear motion is about 15-25 times the force provided in the position depicted in Fig. 5, as readily calculable by the skilled person without undue experimentation given the geometries and materials at hand.

Finally, at the end of the motion, as shown in Fig. 8, the edge 112 has been fully pushed into the gasket 110, providing an electromagnetic seal between the front plate 104 and the body 102.

The inventive concept has mainly been described above with reference to a few embodiments. However, as is readily appreciated by a person skilled in the art, other embodiments than the ones disclosed above are equally possible within the scope of the inventive concept, as defined by the appended patent claims.

**Claims**

1. A TEMPEST-grade electromagnetically shielded electronics cabinet (100), comprising a body (102) and a front plate (104), said cabinet (100) further being provided with a linear motion mechanism (200, 200b) comprising:

   a movable frame (202) slidably suspended with respect to said body (102)), connectable to said front plate (103), and provided with a driving member (210); and
   an actuator plate (208) pivoted at said body (102), and provided with a guiding track (211), wherein said driving member (210) is configured to engage with said guiding track (211) for driving the linear motion upon actuation of said actuator plate (208).

2. The electronics cabinet (100) of claim 1, said linear motion mechanism (200) being a first linear motion mechanism (200) and said cabinet further comprising a second linear motion mechanism (200b), wherein an actuator plate (208) of said second linear motion mechanism is connected to said actuator plate (208) of said first linear motion mechanism (200) through a shaft (400).

3. The electronics cabinet (100) of claim 2, wherein said first linear motion mechanism (100) is located at a first end of said electronics cabinet (100) and said second linear motion mechanism is located at a second end of said electronics cabinet (100), wherein said first end is located opposite to said second end in a direction transversal to said linear motion (D).

4. The electronics cabinet (100) of any one of claims 1-3, one of said body (102) and said front plate (104) being provided with an electromagnetically-sealing gasket (110) and the other of said body (102) and said front plate (104) being provided with an edge (112) fitting into said gasket (110), for electromagnetically sealing said front plate (104) to said body (102).

5. The electronics cabinet (100) of any one of claims 1-4, wherein said front plate (104) is removable from said movable frame (202).

6. The electronics cabinet (100) of any one of claims 1-5, wherein said front plate (104) is attachable to said movable frame (202) through one or more hooks (214) provided at said movable frame (202).

7. The electronics cabinet (100) of any one of claims 1-6, wherein said actuator plate is supported at said body by a spring.

8. The electronics cabinet (100) of claim 7, wherein said spring is a gas spring.

9. The electronics cabinet (100) of any one of claims 1-8, wherein said guiding track (211) of said actuator plate (210) has a variable slope along said guiding track (211).

*Fig. 1*

*Fig. 2*

EP 4 412 415 A1

Fig. 3

Fig. 4

208

211

214

212

112

110

210

*Fig. 6*

208

211

214

212

112

110

210

*Fig. 5*

Fig. 8

Fig. 7

Europäisches
Patentamt
European
Patent Office
Office européen
des brevets

## EUROPEAN SEARCH REPORT

Application Number

EP 24 15 3940

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2020/296846 A1 (JOHANSSON HANS-ERIK [SE]) 17 September 2020 (2020-09-17) <br> * paragraph [0002] * <br> * paragraph [0020] - paragraph [0021] * <br> * paragraph [0064] - paragraph [0079] * <br> * paragraph [0097] - paragraph [0116] * <br> * figures 1,6-16 * | 1-9 | INV. <br> H05K7/14 <br> H05K9/00 |
| A | EP 0 224 090 A2 (EUROSHIELD OY [FI]) 3 June 1987 (1987-06-03) <br> * page 4 - page 11 * <br> * figures 1-4,8 * | 1-9 | |
| A | US 2012/153790 A1 (HAMMER ANDREAS [DE] ET AL) 21 June 2012 (2012-06-21) <br> * paragraph [0001] * <br> * paragraph [0025] - paragraph [0034] * <br> * figures 1-6 * | 1-9 | |
| | | | TECHNICAL FIELDS SEARCHED (IPC) <br><br> H05K <br> H02B <br> E06B <br> E05D |

The present search report has been drawn up for all claims

| Place of search | Date of completion of the search | Examiner |
|---|---|---|
| The Hague | 13 June 2024 | Jorna, Pieter |

EPO FORM 1503 03.82 (P04C01)

## ANNEX TO THE EUROPEAN SEARCH REPORT
## ON EUROPEAN PATENT APPLICATION NO.

EP 24 15 3940

This annex lists the patent family members relating to the patent documents cited in the above-mentioned European search report.
The members are as contained in the European Patent Office EDP file on
The European Patent Office is in no way liable for these particulars which are merely given for the purpose of information.

13-06-2024

| Patent document cited in search report | Publication date | Patent family member(s) | Publication date |
|---|---|---|---|
| US 2020296846 A1 | 17-09-2020 | DK 3424285 T3 | 30-01-2023 |
| | | EP 3424285 A1 | 09-01-2019 |
| | | FI 3424285 T3 | 31-01-2023 |
| | | SE 1650291 A1 | 05-09-2017 |
| | | US 2020296846 A1 | 17-09-2020 |
| | | WO 2017151050 A1 | 08-09-2017 |
| EP 0224090 A2 | 03-06-1987 | CA 1275663 C | 30-10-1990 |
| | | CN 86107736 A | 20-05-1987 |
| | | DK 553386 A | 22-05-1987 |
| | | EP 0224090 A2 | 03-06-1987 |
| | | IE 59485 B1 | 09-03-1994 |
| | | JP H0747916 B2 | 24-05-1995 |
| | | JP S62129490 A | 11-06-1987 |
| | | NO 163026 B | 11-12-1989 |
| | | US 4753038 A | 28-06-1988 |
| US 2012153790 A1 | 21-06-2012 | DE 102009038916 A1 | 03-03-2011 |
| | | EP 2470740 A1 | 04-07-2012 |
| | | US 2012153790 A1 | 21-06-2012 |
| | | WO 2011023314 A1 | 03-03-2011 |

EPO FORM P0459

For more details about this annex : see Official Journal of the European Patent Office, No. 12/82

**REFERENCES CITED IN THE DESCRIPTION**

**Patent documents cited in the description**

- SE 2020050471 W